# EUROPEAN PATENT APPLICATION

(11) **EP 3 588 584 A1**
(43) Date of publication of application: **01.01.2020**
(21) Application number: 18305839.5
(22) Date of filing: 29.06.2018
(51) Int. Cl.: H01L 31/0224, H01L 31/18

(54) **SOLAR CELLS AND METALLIZATION PROCESS AND DEVICE**

(71) Applicant: Total SA, 92400 Courbevoie (FR)
(72) Inventor: DEYINE, Amjad, 94300 VINCENNES (FR); SACHS, Christoph, 78530 BUC (FR)
(74) Representative: Lavoix

(57) **Abstract**

The invention relates to a method or process for preparing a solar cell with at least one metal contact 10, wherein said solar cell 1 comprises a substrate 20 comprising a receiving layer 22 receiving said at least one metal contact 10, wherein said process comprises the following steps:
(i) at least partially coating said receiving layer 22 with a molten metal layer 12,
(ii) cooling said metal layer 12 to solidify the molten metal layer 12 into a solid metal layer 14 forming a metal contact 10, thereby
(iii) providing a solar cell 1 with at least one metal contact 10.

## Description

The present invention relates generally to solar cells, and more particularly relates to metal contact structures for use in solar cells.

### Technological background of the invention

The use of photovoltaic cells (i.e. solar cells) for the conversion of solar radiation into electrical energy is well known.

Solar cells with interdigitated contacts of opposite polarity on the back surface of the cell are known. Such solar cells with interdigitated contacts have numerous advantages over conventional solar cells with front side metal contacts, including improved photoconversion due to elimination of front contact shading, much reduced contact resistance, etc. In addition to the performance advantages, a solar cell structure having back contact allows simplified module assembly due to their coplanar contacts.

Typically a metal contact is provided by depositing a metal layer on a receiving layer of the wafer (substrate).

Aluminum, because of its low cost and good electrical conductivity, is the most common material used to fabricate the back contacts of solar cells. Typically, as taught by US 5,178,685 which describes a method for forming solar cell contacts and interconnecting solar cells, the aluminum back contact is made by coating the rear side of a silicon substrate with liquid compositions comprising metal (aluminum) particles disposed in an organic liquid vehicle. Typically, the aluminum compositions are fired so as to remove the organic vehicle by evaporation and/or pyrolysis and cause the metal particles to alloy with the silicon substrate and thereby form an ohmic aluminum/silicon contact. Unfortunately, aluminum tends to form a surface oxide when exposed to air.

Various methods have been used for overcoming the aluminum soldering problem. Such methods need to be further developed.

For example, according to US 5,178,685, such method comprises forming a contact having improved bond reliability on a silicon solar cell substrate with a metal ink and firing said metal ink at a temperature in the range of 750 to 850 °C.

Such a method of the prior art would necessarily degrade a fragile substrate, such as a passivation layer, which cannot undergo such a heating step (firing) at a temperature in the range of 750 to 850 °C.

Other methods for coating aluminum as metal contact for solar cells include depositing an aluminum layer (foil) on a silicon substrate possibly containing one or more different layers. For example US 2015/0090329 US 9,178,104 and US 9,634,178 relates to such methods. However, methods like laser-welding can only provide localized point contact and hence lead to inhomogeneous contacts between the substrate and the metal contact, thereby limiting conversion efficiency of the solar cell.

In addition, thermo-mechanical issues can also be seen on metallized solar cells. The mismatch in the coefficient of thermal expansion between the silicon substrate (wafer) of the solar cell and the conductive metal layer can lead to mechanical stresses after cooling from the processing temperature. The mechanical stresses can cause bending of the whole device or create local waviness or buckling in case of a thin AI foil. In the worst case, the bond between the two layers breaks down or even the solar cell may crack. The increase of adhesion and different mechanical properties of a metal layer formed directly from a melt may have a positive impact on the reliability of the solar cell device and hence on the conversion efficiency.

### Aims of the invention

One object of this invention is to provide improved metal contacts for solar cells.

The invention aims to solve the technical problem of providing a high through-put process for preparing solar cells while being very cost effective.

The invention aims to solve the technical problem of providing a photovoltaic cell having improved metal contact of the metal layer with the substrate.

The invention aims also to solve the technical problem of providing a more uniform electric contact over a solar cell.

The invention aims also to solve the technical problem of providing an improved adhesion, reduced electric carrier losses at the metal/substrate (device) interface.

The invention aims also to solve the technical problem of providing less chemical residues at the metal/substrate interface.

The invention aims also to solve the technical problem of providing a metal layer able to withstand more mechanical stress during cell processing and service.

The invention aims also to solve the technical problem of providing a metal layer coating a solar cell for forming metal contact while preventing damages of the substrate (typically including different layers) due to said coating.

### Description of the invention

It has been discovered by the present inventors that one or more of the technical problems set forth in the present invention can be overcome by providing a process according to the present invention.

The foregoing and other objectives, features, and advantages of the invention will be more readily understood upon consideration of the following detailed description of the invention taken in conjunction with the accompanying drawings.

For a more complete understanding of the present invention, the drawings illustrate examples of the invention. The drawings thereto, however, do not limit the scope of the invention. In the following detailed description, numerous specific details are set forth in order to provide a thorough understanding of the present invention. However, those skilled in the art will understand that the present invention may be practiced without these specific details, that the present invention is not limited to the depicted embodiments, and that the present invention may be practiced in a variety of alternate embodiments. In other instances, well known methods, procedures, components, and systems have not been described in detail. Also, the present invention covers any combination of different embodiments, preferred and/or advantageous features.

Accordingly, the present invention relates to method or process for preparing a solar cell with at least one metal contact 10, wherein said solar cell 1 comprises a substrate 20 comprising a receiving layer 22 receiving said at least one metal contact 10, wherein said process comprises the following steps:
(i) at least partially coating said receiving layer 22 with a molten metal layer 12,
(ii) cooling said metal layer 12 to solidify the molten metal layer 12 into a solid metal layer 14 forming a metal contact 10, thereby
(iii) providing a solar cell 1 with at least one metal contact 10.

More particularly, the present invention relates to a method or process for preparing one or more metal contacts of a solar cell.

Such a process enables preparing solar cells at low costs and provides a high through-put process. A process according to the invention prevents damaging the solar cell due to said metal molten coating during fabrication of the solar cell.

Such a process enables preparing solar cells having an improved adhesion; thereby it reduces electric carrier losses at the metal/substrate (device) interface.

Such solid metal layer 14 is also able to withstand more mechanical stress during cell processing and service.

Preferably, upon contact of the molten metal 12 with the receiving layer 22, a layer (or film) of molten metal 12 solidifies quickly, preferably instantly, on the surface of the receiving layer 22 of the solar cell 1, thereby forming the solid metal layer 14. Advantageously, the temperature profile of the metal layer 12 and/or the receiving layer 22 and contact time of the metal layer 12 and the receiving layer 22 control the solid metal layer 14 formation and growth. In one embodiment, said cooling (ii) comprises a cooling of said molten metal layer at least partially coating said receiving layer with a temperature profile of the metal layer 12 and/or the receiving layer 22 and a contact time between the metal layer 12 and the receiving layer 22 solidifying said molten metal layer into a solid metal layer before heat provided by said molten metal layer damages said receiving layer. It is understood that molten metal layer 12 does not damage the receiving layer 22 in a way that said receiving layer 22 is not operative anymore for its intended function or that said receiving layer 22 significantly losses its intended function. Typically the receiving layer 22 still acts as a photovoltaic cell after the process of the invention.

Basically, the Landau-Levich relation teaches that for a given liquid coating system, the thickness depends on the translation speed U. For a given viscosity, the translation speed (U) will define the metal film thickness. Also, the contact time depends on the translational speed U. To avoid damages to the solar cell, the process according to the present invention works a translation speed U of the coating step (i) and provides a cooling step (ii) sufficient to solidify quickly the molten metal while avoiding damaging the solar cell. Preferably, such metal solidification is performed as fast as possible after deposition of the molten metal on the receiving layer.

In one embodiment, said coating and cooling steps are carried out under a non-oxidizing atmosphere. In one embodiment, said coating and cooling steps are carried out under an inert atmosphere.

In one embodiment, said coating (i) is performed by meniscus coating, dip coating, spin coating, slot coating, roller coating, curtain coating, draw bar coating and spraying.

In one embodiment, said coating (i) comprises contacting said receiving layer 22 with a molten metal taken from a molten metal reservoir (or bath) to coat at least partially said receiving layer 22 with a molten metal layer 12.

The solar cell is brought into contact with a molten metal such as aluminum for a short period of time to allow solidification of a thin layer. By carefully controlling the temperature profile and the contact time with said molten metal, damage can be avoided to the functional layers of the solar cell.

In one embodiment, said coating (i) is performed by meniscus coating.

Meniscus coating is for example described in the art, for example in US 4,152,471, US 2002/0121239, US 3,201,275, and US 6,017,585 which are incorporated therein by reference. According to the present invention, meniscus coating is performed with molten metal, typically molten aluminum, as a coating material which coats the receiving layer 22 of the solar cell 1. The molten metal forms the fluid coating the substrate. The material is adapted to deposit molten metal, typically molten aluminum, on the substrate 20.

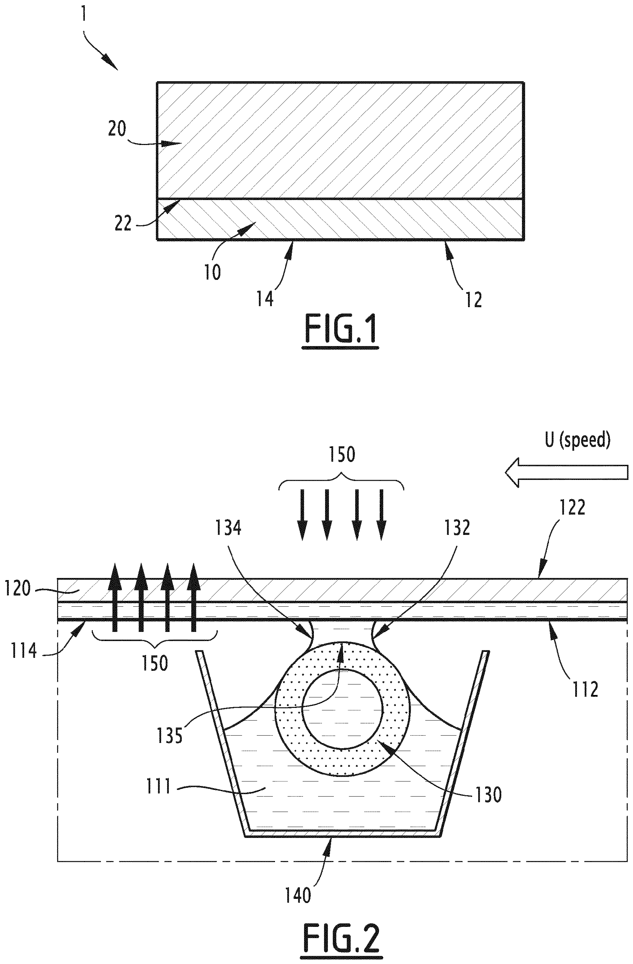

The present invention covers any method for meniscus coating unless it cannot dispense a layer of molten metal on a substrate. Typically, by reference to figure 2 for illustration purpose, a device for meniscus coating comprises a fluid film applicator 130 for applying a layer of molten metal (fluid) 112 taken for a reservoir 140 containing molten metal 111 onto a substrate 120, said fluid film applicator 130 dispensing the molten metal (fluid) 111 so that molten metal 111 is deposited as a continuous layer of molten metal 112 on the substrate 120.

A meniscus may be created between a roller member 130, in rolling contact with a liquid solution of molten metal 111 and a moving substrate 120, i.e., the roll method. Alternately, a meniscus may be generated between a feed nozzle, connected to a source of molten metal 111 solution supply and a moving substrate 120.

In one embodiment, said fluid film applicator 130 comprises a dispensing head 135 and a meniscus forming member that controls the thickness of the molten metal in the continuous layer 112.

In one embodiment, said fluid film applicator 130 comprises a meniscus forming rod having an axis approximately parallel to said line.

Typically, the fluid is dispensed from said dispensing head 135 forms an upstream meniscus 132 and a downstream meniscus 134 relative to the relative motion between the substrate 120 and the fluid film applicator 130.

In one embodiment, the process of the present invention comprises the steps of:
a) providing molten metal 111 to a fluid film applicator 130, so as to develop a flow of the molten metal 111 on an outer surface of the applicator 130;
b) contacting said molten metal 111 on the outer surface of said applicator 130 with the surface of the substrate 120 to be coated to establish menisci of said molten metal 111 between the surface of the substrate 120 and the outer surface of the applicator 130;
c) advancing the surface of the substrate 120 in a substantially horizontal direction across the outer surface of the applicator 130 at a translation speed U; and
d) maintaining and controlling a flow of said molten metal 111 through the wall of the applicator 130 to provide a controlled coating of said molten metal 111 on the surface of said substrate 120;

Typically, the wall of the applicator 130 is permeable to said molten metal.

In one embodiment, the translation speed U varies during the process, for example said translation speed U depends on specific area of the substrate 20,120. In one embodiment, the translation speed U is constant at steady state.

In one embodiment, said coating (i) is performed by dip coating.

For example, the surface of the substrate 20 to be coated by said molten metal 12 is put in contact with the surface of a molten metal bath and removed in a controlled manner to deposit (or coat) a surface of said substrate 20 with said molten metal 12.

In dip coating, for example, the solar cell (substrate) is attached to a holder and then dip into a bath of molten metal. Advantageously, the metal layer growth and thickness is controlled by the temperature profile (melt temperature, substrate temperature and heat extraction) and the residence time of the surface of the receiving layer in the melt. In one embodiment, to achieve a more uniform deposition and improve melt shedding, the immersion and the extraction from the melt (i.e. the molten metal, typically in a reservoir) takes place quickly. In a preferred embodiment, cooling and melt shedding may be enhanced by a gas jet provided above the melt surface that is directed that the substrate holder. For example, the attachment of the solar cell to the holder is possible by using vacuum, for example a vacuum chuck. In one embodiment, to avoid wetting, the substrate holder may be made from a ceramic material such as for example boron nitride.

The coating may be carried out directly on the solar cell or may require a seed layer to enhance adhesion. Accordingly, in one embodiment, said receiving layer comprises seeds on the surface of the receiving layer 22, wherein said seeds guide molten metal coating and/or solidification.

In one embodiment, metal to control the wetting, nucleation and film formation, a seed layer is deposited on the surface of the receiving layer 22 intended to receive the molten.

In one embodiment, said cooling (ii) comprises cooling at least one element selected from the group selected consisting of said substrate 20, said receiving layer 22and said molten metal layer 12, for example by at least one gas flow having a temperature below the temperature of the molten metal.. Typically such gas flow is provided by a cooling system. For example such cooling system is working with a cooling fluid (the thermal transfer device can contain one or more cooling fluid, such as alcohol/solid CO₂ slurries, or other liquid refrigerants, such as those containing liquid nitrogen, liquid helium, liquid argon, liquid neon, liquid xenon or liquid carbon dioxide in combination with solvents.) or with blades (i.e. blade cooling system). In one embodiment, water is the cooling fluid, preferably including additives (for examples anti-corrosion agents, anti-fouling, anti-scaling, etc.). In one embodiment, nitrogen are argon are the preferred inert gas for use as gas jet cooling fluid.

Preferably, cooling is carried out by a cooling system provided on the sample holder during the deposition. For example, the solar cell is attached to the sample holder by the use of a vacuum, providing sufficient mechanical support and low thermal resistant. In one embodiment, the vacuum plenum is made from a highly thermal conductive material, such as copper, and includes internal cooling channels for heat removal. In one embodiment, the surface is coated to prevent contamination of the solar cell. For example, suitable coating materials are selected from the group consisting of AIN, (thin) PTFE layers, other commonly used thermal interface materials, and any mixture thereof. Advantageously, it is crucial to maintain a sharp thermal gradient at the interface to remove the heat of fusion and, in a preferred embodiment, prevent alloying between the AI and Si. Preferably, if the solid metal layer is made from an alloy, the temperature at the interface (at the surface of the layer in contact with the molten metal layer) is preferably below the eutectic temperature of the solid metal layer, for example comprising Al and Si. More preferably, the temperature is not above 300°C, and preferably not above 250°C, for a substantial time to prevent interdiffusion or damage to the functional layers (e.g. passivation, antireflection layers) of the device. In the phase of direct melt contact the heat extraction will be governed by the sample holder, in contrast to the following phase of melt shedding which can be supported by active cooling, e.g. an impinging gas jet or blade.

In one embodiment, said substrate 20 is held by a vacuum chuck.

In one embodiment, cooling (ii) is performed by cooling at least a part of the surface 122 of the substrate 120 opposite the coated surface and/or the surface to be coated.

In one embodiment, cooling (ii) is performed by cooling at least a part of the coated surface and/or the surface to be coated 122 of said substrate 120.

In one embodiment, cooling (ii) is performed by cooling at least a part of said molten metal layer 12,112 and/or by cooling at least a part of said solid metal layer 14,114.

In one embodiment, cooling (ii) is carried out with a cooling system 150 working with a cooling fluid (the arrow on figure 2 showing the direction of cooling).

Cooling (ii) enables fast solidification of the molten metal 12 deposited onto the substrate 20. Fast cooling (ii) enables avoiding damages to the functional layers of the solar cell.

Preferably, cooling (ii) is performed to control the temperature profile of the metal layer 12, 14 coating the receiving layer 22. Preferably, cooling (ii) is performed to control the temperature profile of the receiving layer 22.

Preferably, the temperature profile of the cooling layer is controlled by a controlling the temperature of the sample holder. Advantageously, the back (the part which is not in contact with the molten metal) device is thermalized by the sample holder. Advantageously, the temperature is chosen to optimize the deposition and the solidification.

In one embodiment, the solid metal layer (14) has a uniform thickness, defined as a total thickness variation (TTV) of preferably less than 10% of the overall layer thickness. Such solid metal layer (14) provides thereby a good electric contact over a solar cell.

Typically, the metal layer has a thickness of 10 to 100 micron.

In one embodiment, the solid metal layer 14 has a thickness of less than about 20 microns (µm). In one embodiment, the solid metal layer 14 has a thickness between 10 and 100 microns.

In one embodiment, the substrate comprises a silicon layer. In one embodiment, said silicon layer is in contact with said solid metal layer 14.

In one embodiment, said solid metal layer 14 forms a metal contact 10 selected from the group consisting of a front metal contact, a back metal contact, including any continuous and discontinuous shape of metal contact.

In one embodiment, said solid metal layer 14 forms interdigitated back contacts.

In one embodiment, said solid metal layer 14 is patterned, for example by laser or by applying a pattern to define areas of molten metal coating and areas of absence of metal coating, for example with a mask.

In one embodiment, in case of interdigitated back contact (IBC) solar cells, a laser patterning step or a mask can be used to open and separate positive and negative contacts on the backside. Accordingly, the present invention relates to a method of providing back-contact formation for IBC solar cells. Such method is applicable for solar cells which can be prepared by metal plating process. More generally, the invention may also be applied to a solar cell architecture requiring formation of metal contacts.

It is also possible to apply a pattern to select areas for metal deposition. In one embodiment, a pattern consists of (fine) lines of a heat-resistance material, such as for example ceramic, that are screen-printed onto the solar cell prior to the coating step (i).

The present invention may be used to prepare metallic front contact and/or back contact. When providing a solar cell with both front and back contacts, the steps according to the process of the invention is repeated for coating each side of the solar cell.

The choice of metal is governed by the required high electrical conductivity for solar cell. The desired electrical conductivity is at least 10⁷ S/m, preferably more than 3·10⁷ S/m.

According to the invention the term "metal" designates a single metal or an alloy. A preferred metal to be deposited on the solar cell is aluminum or an alloy thereof. A preferred metal is pure aluminum which has a melting point of 660 °C. 3. Slightly change the melt composition to lower the temperature. Based on the diagram shown in Figure 4, alloying aluminum with 12.7% silicon reduces the melting point to the eutectic temperature of 577°C. However, alloying may reduce the electrical conductivity.

The solar cell 1 may have several functional layers such as passivation layers. In one embodiment, said receiving layer 22 comprises a passivation layer.. Such passivation layers are fragile and may be damaged when exposed to heat. A process according to the invention allows preventing damage to one or more passivation layers.

In one embodiment, said solar cell 1 comprises a silicon layer..

The present invention relates to a method or process for preparing one or more metal contacts of a solar cell.

In one preferred embodiment, said solar cell is an interdigitated back contact (IBC) solar cell.

Also the present invention relates to a device for preparing a solar cell 1 with at least one metal contact 10, wherein said device operates a process as defined in the present invention, for example said device comprises means for providing a solar cell 1, said solar cell 1 comprising a substrate 20 comprising a receiving layer 22, said device comprising means for contacting said receiving layer 22 with a molten metal and at least partially coating said receiving layer 22 with said molten metal thereby forming a molten metal layer 12 on said receiving layer 22, said device comprising a cooling system cooling said molten metal layer 12 thereby solidify the molten metal layer 12 into a solid metal layer 14 and thereby forming a metal contact 10.

The present invention also relates to a solar cell 1 comprising at least one metal contact 10 and a receiving layer 22, wherein said metal contact 10 coats at least partially the receiving layer 22, wherein said solar cell 1 is obtainable by a process as defined in the present invention.

### In the figures:

Figure 1 is a schematic representation of a cross section of a solar cell 1 showing the receiving layer 22, the molten metal layer 12 and the solid metal layer 14 on the substrate 20, wherein said solid metal layer forms a metal contact 10 according to the invention.
Figure 2 is a schematic representation of a meniscus coating process according to the invention.

## Claims

1. A process for preparing a solar cell (1) with at least one metal contact (10), wherein said solar cell (1) comprises a substrate (20) comprising a receiving layer (22) receiving said at least one metal contact (10), wherein said process comprises the following steps:
(i) at least partially coating said receiving layer (22) with a molten metal layer (12),
(ii) cooling said metal layer (12) to solidify the molten metal layer (12) into a solid metal layer (14) forming a metal contact (10), thereby
(iii) providing a solar cell (1) with at least one metal contact (10).

2. The process according to claim 1, wherein said coating (i) is performed by meniscus coating, dip coating, spin coating, slot coating, roller coating, curtain coating, draw bar coating and spraying.

3. The process according to claim 1 or 2, wherein said coating (i) comprises contacting said receiving layer (22) with a molten metal taken from a molten metal reservoir (or bath) to coat at least partially said receiving layer (22) with a molten metal layer (12).

4. The process according to any one of claims 1 to 3, wherein said cooling (ii) comprises a cooling of said molten metal layer (12) at least partially coating said receiving layer (22) with a temperature profile of the metal layer 12 and/or the receiving layer 22 and a contact time between the metal layer 12 and the receiving layer 22 solidifying said molten metal layer (12) into a solid metal layer (14) before heat provided by said molten metal layer (12) damages said receiving layer (22).

5. The process according to any one of claims 1 to 4, wherein said cooling (ii) comprises cooling at least one element selected from the group selected consisting of said substrate (20), said receiving layer (22) and said molten metal layer (12), for example by at least one gas flow having a temperature below the temperature of the molten metal.

6. The process according to any one of claims 1 to 5, wherein said substrate (20) is held by a vacuum chuck.

7. The process according to any one of claims 1 to 6, wherein said solid metal layer (14) has a thickness of 10 to 100 micron.

8. The process according to any one of claims 1 to 7, wherein said solid metal layer (14) forms a metal contact (10) selected from the group consisting of a front metal contact, a back metal contact, including any continuous and discontinuous shape of metal contact.

9. The process according to any one of claims 1 to 7, wherein said solid metal layer (14) forms interdigitated back contacts.

10. The process according to any one of claims 1 to 9, wherein said solid metal layer (14) is patterned, for example by laser or by applying a pattern to define areas of molten metal coating and areas of absence of metal coating, for example with a mask.

11. The process according to any one of claims 1 to 10, wherein said receiving layer (22) comprises seeds on the surface of the receiving layer, wherein said seeds guide molten metal coating and/or solidification.

12. The process according to any one of claims 1 to 11, wherein said receiving layer (22) comprises a passivation layer.

13. The process according to any one of claims 1 to 12, wherein said solar cell (1) comprises a silicon layer.

14. A device for preparing a solar cell (1) with at least one metal contact (10), wherein said device operates a process as defined in any one of claims 1 to 13, for example said device comprises means for providing a solar cell (1), said solar cell (1) comprising a substrate (20) comprising a receiving layer (22), said device comprising means for contacting said receiving layer (22) with a molten metal and at least partially coating said receiving layer (22) with said molten metal thereby forming a molten metal layer (12) on said receiving layer (22), said device comprising a cooling system cooling said molten metal layer (12) thereby solidify the molten metal layer (12) into a solid metal layer (14) and thereby forming a metal contact (10).

15. A solar cell (1), said solar cell (1) comprising at least one metal contact (10) and a receiving layer (22), wherein said metal contact (10) coats at least partially the receiving layer (22), wherein said solar cell is obtainable by a process as defined in any one of claims 1 to 13.
